# EUROPEAN PATENT APPLICATION

(11) **EP 2 899 991 A1**
(43) Date of publication of application: **29.07.2015**
(21) Application number: 14290006.7
(22) Date of filing: 24.01.2014
(51) Int. Cl.: H04Q 11/04, H03M 13/27

(54) **Space time switch and bit interleaver**

(71) Applicant: ALCATEL LUCENT, 92100 Boulogne-Billancourt (FR)
(72) Inventor: Boislaigue, Roger, 91620 Nozay (FR); Dupas, Arnaud, 91620 Nozay (FR)
(74) Representative: Croonenbroek, Thomas Jakob

(57) **Abstract**

The present invention refers to a space time switch (1) comprising up to M input ports (IP) and up to N output ports (OP), the said space time switch (1) also comprises processing means (3) configured for:
- reading within one clock cycle up to N bits on its input ports (IP), the said N bits being read from F bit-sets (BS) of respective F data streams (OD),
- switching within one clock cycle up to N read bits onto the N respective output ports (OP),
wherein the processing means (3) are implemented by programmable components configured for processing up to N bits in parallel simultaneously.

## Description

### BACKGROUND OF THE INVENTION

The present invention relates to the field of data streams processing and more particularly to the switching of a plurality of data streams.

In telecommunication networks, data streams need to be processed in order for the data streams to be transmitted to their destination. Thus, in a network node, a plurality of data streams having potentially different bit rates need to be switched toward their destination. In some cases, the bit rate of some data streams need to be modified to be adapted to the network capacities. In further cases, several data streams need to be combined to be sent to a common destination, for example using a bit interleaving scheme, particularly to reduce energy consumption of electronics for high bandwidth transmission.

However, with the solutions of the state of the art, the switching or the combination of a plurality of data streams introduce latencies and/or require huge computational capacities to process and combine the different streams.

### SUMMARY OF THE INVENTION

It is therefore an object of the present invention to overcome the above mentioned drawbacks of the state of the art and to provide a solution that enables processing a plurality of data streams that need to be switched with minimal latencies and processing capacities.

Thus, the present invention refers to a space time switch comprising up to M input ports and up to N output ports, the said space time switch also comprises processing means configured for:
- reading within one clock cycle up to N bits on its input ports, the said N bits being read from F bit-sets of respective F data streams,
- switching within one clock cycle up to N read bits onto the N respective output ports,
wherein the processing means are implemented by programmable components configured for processing up to N bits in parallel simultaneously.

According to another aspect of the invention, the programmable components are Field Programmable Gate Array "FPGA" or Application Specific Integrated Circuit "ASIC" components or a combination of Field Programmable Gate Array "FPGA" components with a system on chip "SoC".

According to a further aspect of the invention, the output ports comprise k sub-ports, the processing means comprise at least N*k bit shift modules wherein a bit shift module is configured for:
- reading a data bit from one of the F bit-sets,
- receiving an index of an output port associated to the read bit and,
- providing, within one clock cycle, an intermediate vector comprising N*k bits with one data bit corresponding to the read bit, the position of the data bit in the intermediate vector being computed according to the index of the associated output port, the other bits of the intermediate vector being null values and the respective N*k bits of the intermediate vector being sent to one of the k sub-ports of the respective N output ports.

According to an additional aspect of the invention, the space time switch comprises inputs for receiving a rate and an offset associated with the F respective bit-sets and the processing means comprise:
- at least N bit shift modules wherein a bit shift module comprises
   - an input for receiving a bit read from one of the F bit-sets,
   - an input for receiving an index of the read bit within the bit-set,
   - an input for receiving an offset associated to the bit-set,
   - an input for receiving a rate associated to the bit-set,
      and is configured for providing, within one clock cycle, an intermediate vector comprising N bits with one data bit corresponding to the read bit, the position of the data bit in the intermediate vector being computed according to:
   - the index of the received bit within the bit set,
   - the offset associated with the bit-set,
   - the rate associated with the bit-set,
      the N respective bits of the intermediate vector being sent to the respective N output ports to form an output vector,
- at least N bit position modules wherein a bit position module comprises
   - an input for receiving an index of the bit within the bit-set,
   - an input for receiving an offset associated to the bit-set,
   - an input for receiving a rate associated to the bit-set,
   - an input for receiving the position of the bit-set within the data stream and is configured for providing
   - a first intermediate vector comprising N bits with one enabling bit, the position of the enabling bit being computed according to the index of the received bit within the bit set, the offset and rate associated with the bit-set, the respective bits of the first intermediate vector being sent to the respective N output ports to form an output vector,
   - a second intermediate vector comprising N sub-vectors of abs(log₂(L)) bits with one address sub-vector, the position of the address sub-vector being computed according to the index of the received bit within the bit set, the offset and rate associated with the bit-set, the position of the bit-set within a global output frame, the respective sub-vectors of the second intermediate vector being sent to the respective N output ports o form an output vector.

According to another aspect of the invention, the bit shift modules and bit position modules comprise inputs configured for receiving a clock signal enabling the synchronization of the said bit shift and bit position modules.

The embodiments of the present invention also refer to a bit interleaver comprising:
- a space time switch,
- a memory reader operable to receive up to M data streams having respective bit-rates and to provide up to M bit-sets to the input ports of the space time switch,
- N OR-function modules linked respectively to the N output ports and operable to determine within one clock cycle a single output bit based on one of said respective output vectors,
- N memory elements linked respectively to the N OR-function modules and comprising respectively at least L sub-elements having respective sub-addresses, the said memory elements being operable to write within one clock cycle one single output bit into one of its bit sub-elements.

According to another aspect of the invention, the OR-function modules comprise:
- a first OR-function element comprising N inputs for receiving an output vector comprising N bits received from N bit shift modules and configured for providing one output bit based on the OR function to the associated memory element,
- a second OR-function element comprising N inputs for receiving an output vector comprising N bits received from N bit position modules and configured for providing one output bit based on the OR function to the associated memory element,
- a third OR-function element comprising N inputs for receiving N output vectors comprising abs(log₂(L)) bits from N bit position modules and configured for providing a vector of abs(log₂(L)) bits based on the OR-function to the associated memory element.

According to a further aspect of the invention, the bit interleaver comprises a control unit configured for providing, to the bit shift modules and to the bit position modules, the rate and the offset associated with the bit-sets that the bit shift modules and the bit position modules have to process.

According to an additional aspect of the invention, the control unit is configured for providing a clock signal to the bit shift modules and to the bit position modules and wherein a bit shift module and an associated bit position module are configured to be clocked based on the same clock signal.

According to another aspect of the invention, the bit shift modules and associated bit position modules are combined respectively to form N processing modules.

According to a further aspect of the invention, the bit interleaver comprises a memory reader operable to receive and provide a number of F data streams with respective rates.

According to another aspect of the invention, the rate associated to a bit-set provided by the control unit is selected to be lower than the rate of the received data stream comprising the said bit-set leading to a modification of the rate of the data stream within the output global frame.

According to a further aspect of the invention, the bit interleaver is located in an optical line terminal of an optical access network wherein:
- the memory reader is operable to receive and provide a number of F data streams assigned to respective optical network units,
- the control unit is operable to control:
   - the reading of said M data streams by the space time switch,
   - the switching of the said space time switch onto said output ports and
   - the writing of the single output bits within the memory elements according to a calculated pattern.

The embodiments of the present invention also refer to an optical line terminal for an optical access network comprising a bit interleaver.

### BRIEF DESCRIPTION OF THE DRAWINGS

FIG.**1** is a diagram of a space time switch according to the embodiments of the present invention;
FIG.**2** is a diagram of a space time switch according to a first embodiment of the present invention in the case of a bit granularity;
FIG.**3** is a diagram of an alternate representation of the space time switch represented in fig.2;
FIG.**4** is a diagram of a space time switch according to a first embodiment of the present invention in the case of a two bit granularity;
FIG.**5** is a diagram of a bit interleaver with the space time switch according to a second embodiment of the present invention;
FIG.**6** is a diagram of a part of a space time switch in a bit interleaver according to a second embodiment of the present invention;
FIG.7**a** represents four bit sets received from four data streams;
FIG.**7b** represents the desired output global frame at the output of the bit interleaver;
FIG.**7c** represents the sets of bits read from the memory elements;
FIG.**8a** represents the reception of single output bits and their storing in the memory elements at time t=0;
FIG.**8b** represents the reception of single output bits and their storing in the memory elements at time t=1;
FIG.**8c** represents the reception of single output bits and their storing in the memory elements at time t=2;
FIG.**9** represents the the global output frame obtained by reading successively the memory elements;
FIG.**10a** represents four bit sets received from four data streams;
FIG.**10b** represents the desired output global frame at the output of the bit interleaver;
FIG.**10c** represents the sets of bits read from the memory elements;
FIG.**11a** represents the reception of single output bits and their storing in the memory elements at time t=0;
FIG.**11b** represents the reception of single output bits and their storing in the memory elements at time t=1;
FIG.**11c** represents the reception of single output bits and their storing in the memory elements at time t=2;
FIG.**12** represents the the global output frame obtained by reading successively the memory elements;

In these drawings, the elements having the same reference correspond to elements having a similar function.

Furthermore, for references made of a combination of letter(s) and numbers, the letter(s) represent(s) a class of objects being identical and the number represents a particular element of the class. For example the class corresponding to the memories is noted M and M2 is a particular memory element among the class M.

### DETAILED DESCRIPTION OF THE INVENTION

The embodiments of the present invention refer to a space time switch configured for switching bits received on its input ports from a respective plurality of input data streams toward its output ports.

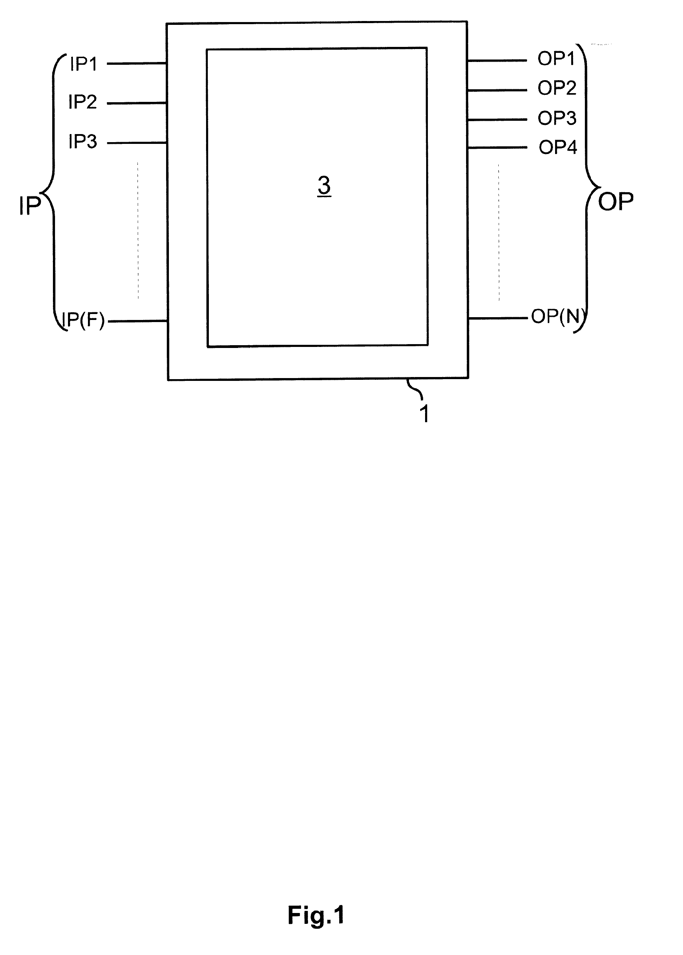

Fig.1 represents a diagram of a space time switch 1 comprising F input ports IP noted IP1...IP(F) and N output ports OP noted OP1...OP(N).

The space time switch 1 also comprises processing means 3 configured for reading up to N bits received on its input ports IP within one clock cycle, the said N bits being read from F bit-sets of F respective data streams and for switching within one clock cycle the up to N read bits onto the N respective output ports OP. The processing means are implemented by programmable components configured for processing the said N bits in parallel simultaneously. The programmable components are for example Field Programmable Gate Array (FPGA) or Application Specific Integrated Circuit (ASIC) components or a combination of FPGA components with a system on chip (SoC).

Different embodiments corresponding to different functions of the space time switch 1 will now be described.

### 1) Space time switch as an N*N switch when no bit interleaving is required

According to a first embodiment, the space time switch 1 is used to produce an N*N switch which is actually a N(k)*N(k) switch comprising N input ports IP of k bits width value (where k can take values like 1,2,4,8,16,32 or more) configured for receiving N respective data bit streams and N output ports OP wherein, within one clock cycle, bits of each data stream received on the input ports are transmitted toward an output port OP providing a simultaneous switching of N data streams with a k-bits granularity (for example a bit, a byte, a word or a double word granularity). The configuration of the space time switch 1 can be modified at any time to switch a data bit stream received on an input port toward another output port.

In this embodiment, the processing means 3 of the space time switch 1 comprise N*k bit shift modules BSM1,...,BSM(N*k) operable for processing the bits between the input ports IP and the output ports OP. A bit shift module BSM comprises a first input configured for receiving a bit read from one of the N input ports and a second input configured for receiving index value representative of an output port OP associated and the width value of the input port IP to the read bit. The associated output port OP refers to the output port OP toward which the read bit has to be transmitted.

The bit shift module is configured for providing, within one clock cycle, an intermediate vector IV comprising N*k bits,bits with one data bit corresponding to the received bit, the position of the data bit being computed according to the index of the predetermined targeted output port OP. The received bit is inserted and shifted with a bit shifting process along a null vector of N*k bits to the calculated position.

Thus, each bit shift module BSM produces at each clock cycle an intermediate vector IV of N*k bits and one of the N*k bits is transmitted respectively to a sub-port SP of each output port OP to produce an output vector V. Each sub-port SP comprises an OR function which will be described in more details in the following of the description wherein only one bit is selected among the N bits of the output vector V received by the sub-port SP. For each output port OP of k sub-ports SPs, the bits obtained at the output of each OR function produce a k bit vector corresponding to the vector received at the input port IP.

With such configuration, vectors of k bits can be switched from one input port IP to one output port OP, the k bits being switched simultaneously within one clock cycle (actually one clock cycle to be received by a bit shift module BSM, another clock cycle to be sent to an output port OP within an intermediate vector IV and a further clock cycle to be processed by an OR function and concatenated within an output vector V (possibly a single bit vector)).

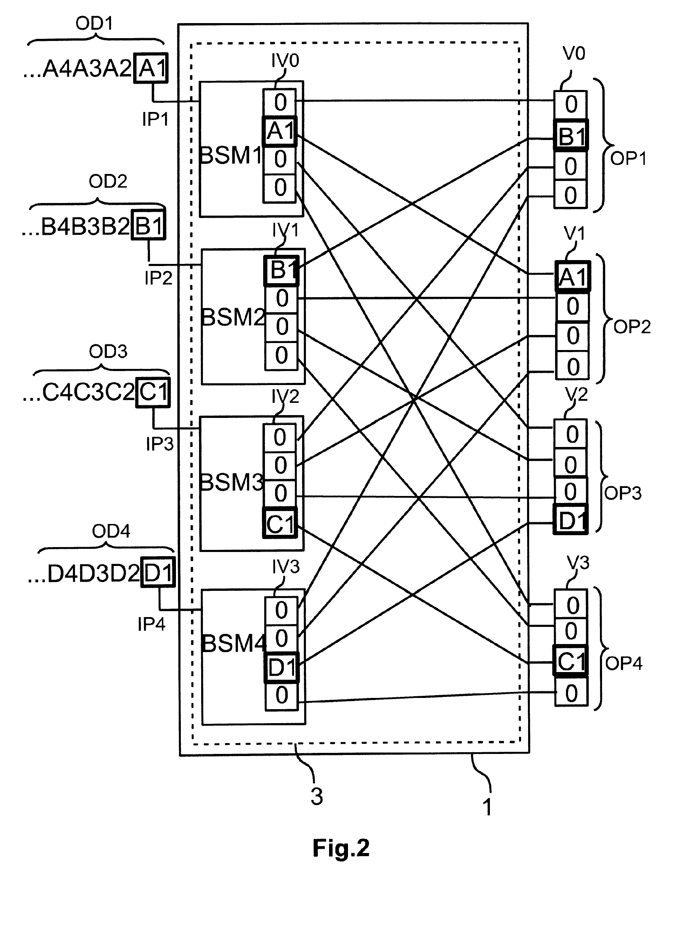

Fig.2 represents an example of space time switch 1 having a 4(1 bit)*4(1 bit) switch configuration.

In the present case, it is supposed that the four data streams OD1...OD4 have the same rate.

The processing means 3 of the space time switch 1 comprise four bit shift modules noted BS1, BS2, BS3 and BS4 associated respectively to the input ports IP1, IP2, IP3 and IP4.

At each clock cycle a data bit of the data streams OD1...OD4 is read by one of the bit shift modules BSM1...BSM4 through one of the four input ports IP1, IP2, IP3 and IP4. In the present case, the read data bits are respectively A1, B1, C1 and D1 and correspond to a 0 or 1 value.

The four bit shift modules BSM1...BSM4 produce respectively four intermediate vectors noted respectively IV0, IV1, IV2 and IV3 comprising four bits each. The intermediate vectors IVO...IV3 comprise the data bit read on the input port IP at the target computed position. The three other bits are the remaining given by the data bit shift from the null vector. The position of the data bit within the intermediate vector IV is determined according to the index of the output port OP corresponding to the destination of the data bit. This index may be provided by a control unit external to the space time switch 1.

In this figure we have 4 inputs IP1, IP2, IP3 and IP4 of 4 one bit vector ,with respectively A1,A2,A3,...An for IP1,B1,B2,B3,...Bn for IP2 , C1,C2,C3,...Cn for IP3 ,D1,D2,D3...Dn for IP4.Targeted position for switching are IP1->OP2,IP2->OP1,IP3->OP4,IP4->OP3

For example, for the first bit shift module BSM1, the data bit read on the input port IP1 is A1 and the destination of this data bit is the second output port OP2. The data bit is therefore introduced in the second position within the intermediate vector IV0. The intermediate vector IV0 is therefore [0, A1, 0, 0]. In the same way, the second bit shift module BS2 read the data bit B1 from the second input port IP2 and receives the instruction of sending this data bit to the first output port OP1. The intermediate vector IV1 corresponds therefore to [B1, 0, 0, 0]. The bit shift modules are then configured for transmitting the first bit of the intermediate vector IV toward the first output port OP1, the second bit of the intermediate vector IV toward the second output port OP2 and so on so that each output port OP1...OP4 receives an output vector V0...V3 composed of the four bits received from the four bit shift modules BSM1...BSM4. The output vector V0 received by the first output port OP1 is [0, B1, 0, 0].

The bits received by the output ports OP from the respective bit shift modules BSM1...BSM4 are gathered to produce an output vector V. An OR-function element 00...03 (not represented) is implemented in each of the output port OP1...OP4 for retrieving the data bit by applying a boolean OR operation to the bits of the output vector V. With a [0, B1, 0, 0] output vector, the retrieved data bit is B1 which can have a 0 or 1 value.

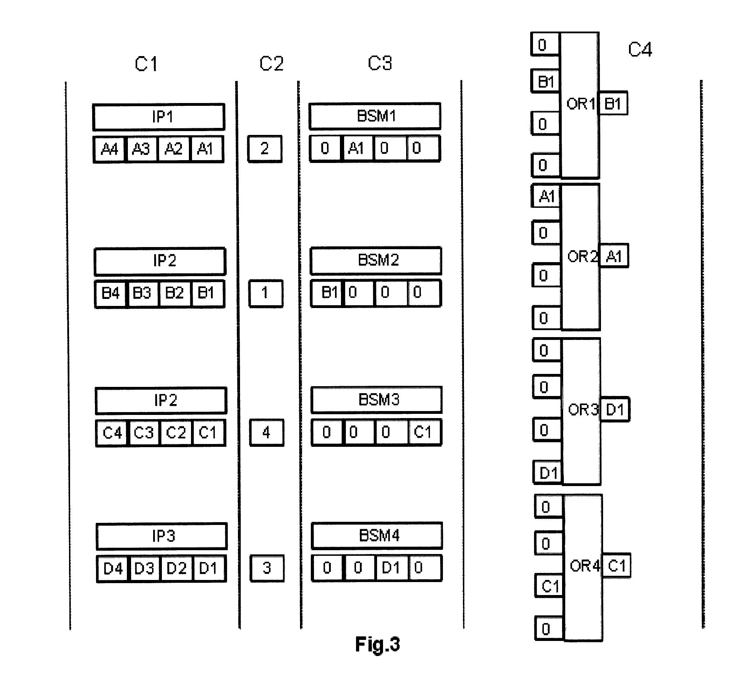

Fig.3 represents an alternate representation of the space time switch of figure 2. In Fig.3, the first column C1 corresponds to the input ports IP and represents the bits received on the different input ports (A1...A4 on input port IP1...). The second column C2 represents the value of the targeted output port OP associated with the input port located on the same line. For example the output number 1 is associated with IP2 so that the read bit on IP1, A1 in the present case, is shifted toward the position in the output vector V1 corresponding to the output port OP2, the second position in the present case. The third column C3 represents the bit shift modules BSMs and the intermediate vector IV produce by each bit shift module BSM. The fourth column C4 represents the OR-function with the output vectors received on their inputs and the bit transmitted on their output, the output vectors corresponding to the output vectors obtained in Fig.2.

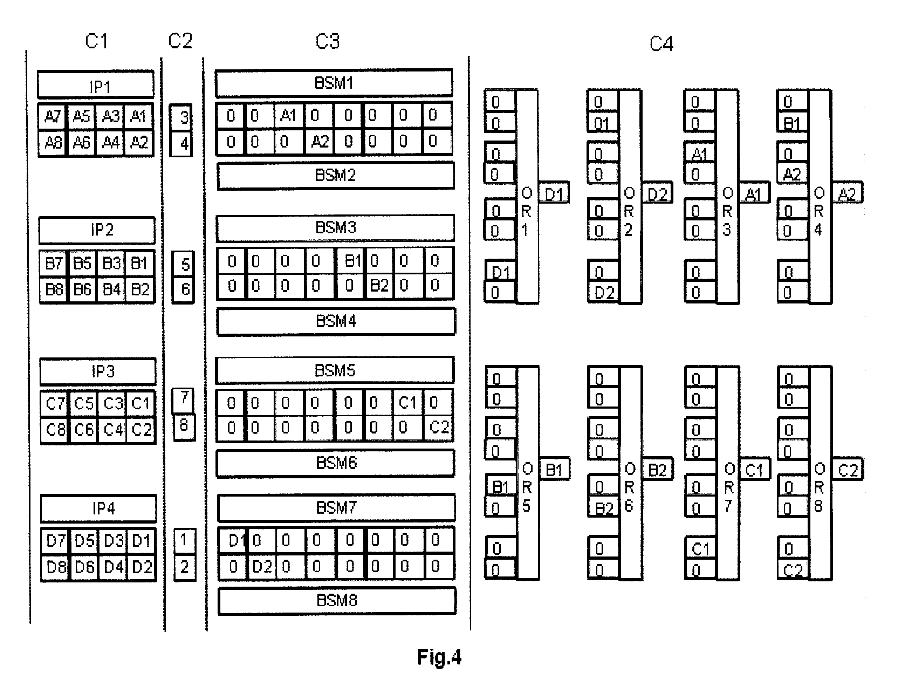

Fig.4 represents another example of a space time switch 1 having a N(2 bits)*N(2 bits) switch configuration with N= 4. It is supposed that the 4 data streams OD1 ,OD2,OD3and OD4 have the same rate.

The processing means 3 of the space time switch 1 comprise eight bit shift modules noted BSM1, BSM2, BSM3 BSM4 BSM5 BSM6 BSM7 and BSM8. BS1 and BS2 are associated to the input port IP1, BS3 and BS4 are associated to the input port IP2, BS5 and BS6 are associated to the input port IP3 and BS7 and BS8 are associated to the input port IP4.

At each clock cycle two data bits of each data streams OD1...OD4 are read, one bit being read by one of the bit shift modules BSM1...BSM8. In the present case, the read data bits are respectively A1,A2 from the first input port IP1,B1,B2 from the second input port IP2, C1,C2 from the third input port IP3 and D1,D2 from the fourth input port IP4.

The eight bit shift modules BSM1...BSM8 produce respectively eight intermediate vectors comprising eight bits each represented in the third column next to the corresponding bit shift module BSM. The intermediate vectors comprise the data bit read on the input port IP at the target computed position. The seven other bits are the remaining given by the data bit shift from the null vector (the read bit is inserted within a null vector of eight bits). The position of the data bit within the intermediate vector IV is determined according to the index of the output port OP corresponding to the destination of the data bit and given in the second column C2. This index may be provided by a control unit external to the space time switch 1.

For example, for the first bit shift module BSM1, the data bit read from the input port IP1 is A1 and the destination of this data bit is the third output port OP3. The data bit is therefore introduced in the third position within the intermediate vector associated with BSM1. The intermediate vector, which can be noted IV0, is therefore [0, 0, A1, 0, 0, 0, 0, 0]. In the same way, the second bit shift module BSM2 read the data bit A2 from the first input port IP1 and receives the instruction of sending this data bit to the fourth output port OP4. The intermediate vector associated with BSM2 corresponds therefore to [0, 0, 0, A2, 0, 0, 0, 0].

For the third bit shift module BSM3, the data bit read from the input port IP2 is B1 and the destination of this data bit is the fifth output port OP5. The data bit is therefore introduced in the firfth position within the intermediate vector associated with BSM3. This intermediate vector is therefore [0, 0, 0, 0, B1, 000]. In the same way, the fourth bit shift module BSM4 read the data bit B2 from the second input port IP2 and receives the instruction of sending this data bit to the sixth output port OP6. The intermediate vector associated with BSM4 corresponds therefore to [0, 0, 0, 0, 0, B2, 0, 0].

Accordingly, the bit shift modules BSM5...BSM8 read bits from IP3 and IP4 f and provide intermediate vectors wherein the data bit is positioned based on the targeted output vector indicated in column C2.

The first bit shift module BSM1 is then configured for transmitting the first bit of the intermediate vector IV0 toward the first sub-port of the first output port OP1 corresponding to the first OR-function element OR1 represented in the fourth column C4 in figure 4, the second bit shift module BSM2 is configured for transmitting the first bit of the intermediate vector IV1 toward the second sub-port of the first output port OP1. Accordingly, the other bit shift modules BSMs are configured the first bit of the intermediate vector toward the OR-function element OR1 of the first output port OP1. The second bit of the intermediate vectors are sent toward the same sub-port (as the first bit of the intermediate vector) of the second OR-function element OR2 associated with the second output port OP2.

Thus, each OR-function element associated with a corresponding output port OP receives an output vector V composed of one bit received from each of the eight bit shift modules BSMs. For example, the output vector received by the first OR-function element OR1 associated with the first output port OP1 is [0, 0, 0, 0, 0, 0, D1, 0] as represented in the fourth column C4 in figure 4. The bit obtained at the output of the first OR-function OR1 is therefore D1 which has a value of 0 or 1. Accordingly, the other OR-functions element OR provide a data bit at their output corresponding to one of the data bit read on the input port IP according to the target output port given in the second column C2. Thus, as for the N(1 bit)*N(1bit) configuration presented previously, the N(2bits)*N(2bits) enables to shift simultaneously the vectors of two bits received on N respective inputs toward N respective output ports with requiring huge processing means. Furthermore, the space time switch can be reconfigured at any time to modify the targeted output port and to forward the bits received on an input toward a different output.

Besides, clock signals are sent to the bit shift modules BSM1...BSM8 in order to synchronize the different bit shift modules so that the bits are transmitted simultaneously towards the output ports OP. Such clock signals may also be provided by an external control unit. The use of intermediate and output vectors enables such synchronization as the OR-function elements need to receive eight bits from the eightdifferent bit shift modules BSMs simultaneously.

Thus, a space time switch 1 according to this first embodiment enables switching simultaneously a plurality of data streams with a bit granularity or other granularities so that no latency is introduced for the switching even with high bit rates data streams.

### 2) Space time switch as a part of a bit interleaver

According to a second embodiment, the space time switch 1 is used in a bit interleaver for interleaving the bits of the received input data streams within a common output data stream. Such bit interleaver is implemented for example in an optical line terminal (OLT) of a passive optical network (PON) to interleave a plurality of input streams into a single interleaved stream sent to the different optical network units (ONUs).

In this embodiment, the processing means 3 of the space time switch 1 comprises two types of processing modules that are complementary. On one side, bit shift modules BSM for reading a data bit at each clock cycle and for switching the data bit toward an output port OP and, on the other side, bit position modules BPM for managing the writing in memory of the read data bits. The bit position modules BPMs are associated with respective bit shift modules BSMs and the number of bit shift and bit position modules may vary according to the capacity of the space time switch 1.

In order to better understand the functioning of these modules, the bit interleaver architecture will now be described.

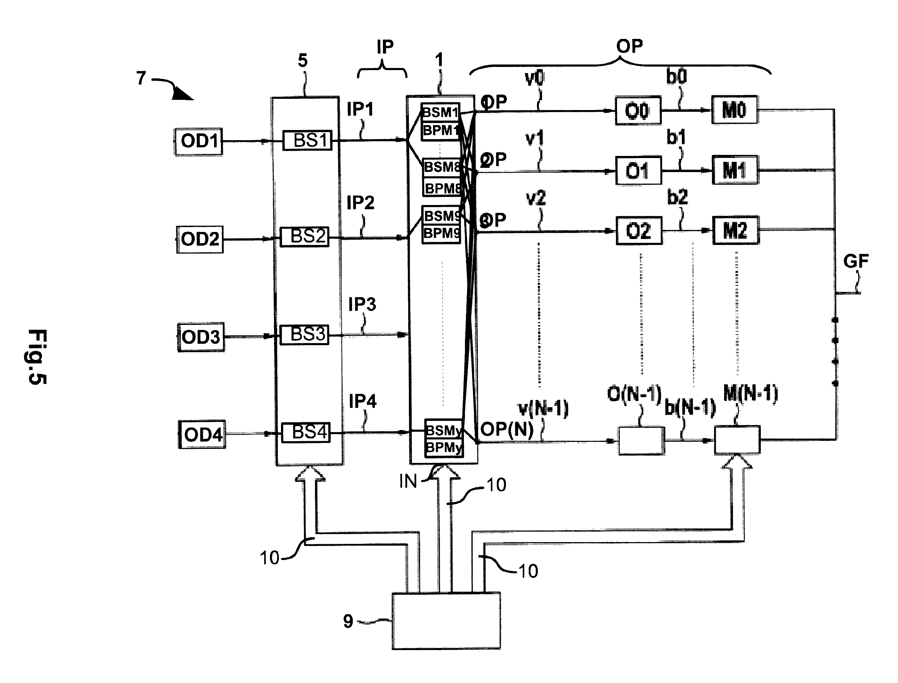

Figure 5 shows a space time 1 of a bit-interleaver 7 according to an embodiment of the present invention.

The bit interleaver 7 contains a FIFO (First In First Out)-reader 5, which receives F different data streams OD with F= 4 in the present case without any limitation. The FIFO-reader 5 is one example of a memory reader that can be used for receiving and reading the different data streams OD1, ...,OD4. Alternative types of memory readers may also be used instead.

The FIFO-reader 5 receives the different data streams OD1,...,OD4. The said data streams have a given bit rate which can be different from one data stream to another. The FIFO-reader 5 receives within a reading cycle up to F respective bit sets BS, four in the present case noted BS1, BS2, BS3 and BS4 without any limitations, the said four bit sets are extracted from the respective data streams OD1,...,OD4. Each of the bit sets BS contains K bits. In this example, the number K of bits within a bit set BS is chosen to be K=8 without any limitation. Thus, in the present case, the FIFO-reader 5 can receive up to four bit-sets comprising each, up to 8 bits at each clock cycle.

The space-time switch 1 is linked to the FIFO-reader 5 through its input ports IP noted IP1,..., IP4. The bit shift modules BSM1...BSMy of the space time switch 1 are therefore able to read any bits from the bit sets associated with an input port IP and several bit shift modules BSM1...BSMy may read simultaneously bits from a single bit set BS. The space time switch 1 may therefore receive within one reading cycle a set of K=8 bits from a single data stream OD if eight bit shift modules BSM and eight bit position modules BPM are assigned to a bit set BS as represented for the input port IP1 in Fig.5. Each bit shift module BSM and bit position module BPM processes one of the bits of the bit set BS. If the different data streams OD1,..., OD4 have the same bit rate or data rate, the same number of bit shift modules BSM is assigned to each bit sets.

However, the different data streams OD1, ..., OD4 may have different bit rates or data rates. In such case, the number of bit shift modules BSM and bit position modules BPM assigned to a bit set BS may vary according to the bit rate of the data stream OD. Some bit sets BS may also be unprocessed during one or several clock cycles to adapt to slower bit rates. Furthermore, with lower bit rate, a bit shift module BSM may be used to read bits sets from different data streams in order to minimize the required number of bit shift modules. For example, a bit shift module may process a bit coming from the first data stream OD1 during one clock cycle and may process a bit coming from the second data stream OD2 during the next clock cycle so that one bit shift module is used to process bits from different bit sets alternatively. It can also process several bits from the first data stream OD1 during several clock cycle and then one bit from the second data stream OD2 during a next clock cycle depending on the rates of the different data streams.

The space-time switch 1 switches within one writing cycle up to Z bits (the maximum number of bits that can be switched depends on the number of bits that can be read within one cycle (4*8=32 in the present case) and on the number of output ports OP if the number of output ports OP is lower than the number of bits that can be read) onto up to N output ports OP (N is for example equal to 16, 32 or 64 without any limitations) of the space time switch 1.

At each of the N output ports, a respective output vector v0, ..., v(N-1) is provided. The output vectors v0, ..., v(N-1) comprise N bits.

In which way the space time switch 1 switches the bits from the data streams OD into the output vectors v0,..., v(N-1) will be described in detail later on.

The bit interleaver 7 also comprises a control unit 9 which is connected to the space time switch 1 and the FIFO reader 5 through links 10 configured for transmitting control parameters. The control unit 9 controls the reading of the data streams OD from the FIFO-reader 5 by the bit shift modules BSM1...BSMy of the space-time switch 1.

Indeed, the control unit 9 sends to the bit shift modules BSM1...BSMy control parameters corresponding to instructions indicating the bit that the bit shift module BSM has to process and indications to determine the output port OP1...OPN toward which the processed bit has to be transmitted. The different instructions will be described in more details in the following of the description.

Furthermore, the control unit 9 controls, in which way the bit shift modules BSMs of the space time switch 1 switch the read bits onto the output ports OP to provide the respective output vectors v0,..., v(N-1).

The resulting output vectors v0,..., v(N-1) are then provided to N respective OR-function modules O0, ..., O(N-1) of the space time switch 1 that are linked respectively to the N output ports OP. The output ports OP comprise N entries (not represented in Fig.5) and the N bits of the received output vector v are transmitted to the respective N entries. Each entry is linked to an input of the OR-function module associated with the output port OP.

The OR-function module O0 determines within one writing cycle a single output bit b0 based on the received bits of the output vector v0. For this, the OR-function module O0 combines all the bits present within the vector v0 and received through the entries by a boolean OR-function. The respective further OR-function modules O1, ...,O(N-1) determine from the respective vectors v1,..., v(N-1) respective single output bits b1, ...,b(N-1).

The bit interleaver 7 also comprises N memory elements M of 1 bit width (of which the size (length) may be adapted according to the needs of the bit interleaver) linked respectively to the N OR-function modules and comprising respectively at least L sub-elements having respective sub-addresses, the said memory elements M, noted M0, M1,...M(N-1), being operable to write within one clock cycle a respective single output bit into a respective one of its sub-elements.

A determined single output bit b0, ..., b(N-1) is therefore provided to the respective memory element M0, ..., M(N-1). Within one writing cycle, a memory element M0,..., M(N-1) writes a respective single output bit b0, ..., b(N-1) into one of its sub-elements. The choice of the writing address, which determines to which sub-element a memory element M0, ..., M(N-1) writes the respective received output bit b0, ...., b(N-1), is chosen by the control unit 9 which is linked to the different memory elements M through links 10 configured for transmitting the control parameters.

The bit interleaver module 7 is therefore able to provide within one writing cycle up to N output bits b to the respective memory elements M0, ..., M(N-1), from which these output bits can be read out as a whole within one reading cycle. Thus, after having written within one writing cycle up to N bits into the memory elements M0, ..., M(N-1), these N bits can then be read out within a reading cycle. Furthermore, several writing cycles of N bits may be achieved before the written bits be read out during a reading cycle. The bits read from the N memory elements are gathered in an interleaved output global vector comprising the interleaving of the input bits from the different data streams. The said interleaved output global vector corresponds to a global output frame GF that can be transmitted toward optical network units (ONUs) of the network.

Even furthermore, since the rates, at which the space time switch 1 reads the bit sets BS1,..., BS4 of the data streams OD1, ..., OD4, is controlled by the control unit 9, and since furthermore the switching properties of the space time switch 1 as well as the reading and the writing addresses of the memory elements M0, ..., M(N-1) are controlled by the control unit 9, the proposed bit interleaver 7 is a solution of great flexibility, allowing the control unit 9 to achieve different data rates for the different data streams OD1, ..., OD4 with a low latency at high speed bit interleaving.

Preferably, the control unit 9 is provided with pre-determined data rates R(i) provided by a bit interleaving passive optical network (Bipon) protocol, wherein the index i of a data stream OD in this example ranges from i=1 to F=4. The control unit 9 uses these predetermined data rates R(i) which are determined according to the requested bandwidth for the data stream OD, for controlling the reading of the bits sets BS 1..BS4 by the space switch 1 from the FIFO reader 5.

Furthermore, the control unit 9 computes offset values o(i), with index i, which define an offset of the different bits of the different data streams OD1 ... OD4 within a global output frame GF. These offsets enable distributing the bits of the different data streams among the plurality of memory elements M.

Even furthermore, the control unit 9 is provided with a predetermined value B of bits present within a global output frame GF and also the number N of the memory elements, as well as the number L of the bit sub-elements of a memory element M. Thus, the control unit 9 chooses the output port OP1...OP(N) and the writing addresses in dependence on required data rates and required offset values.

The organization of the processing means 3 of the space time switch 1 will now be described in details.

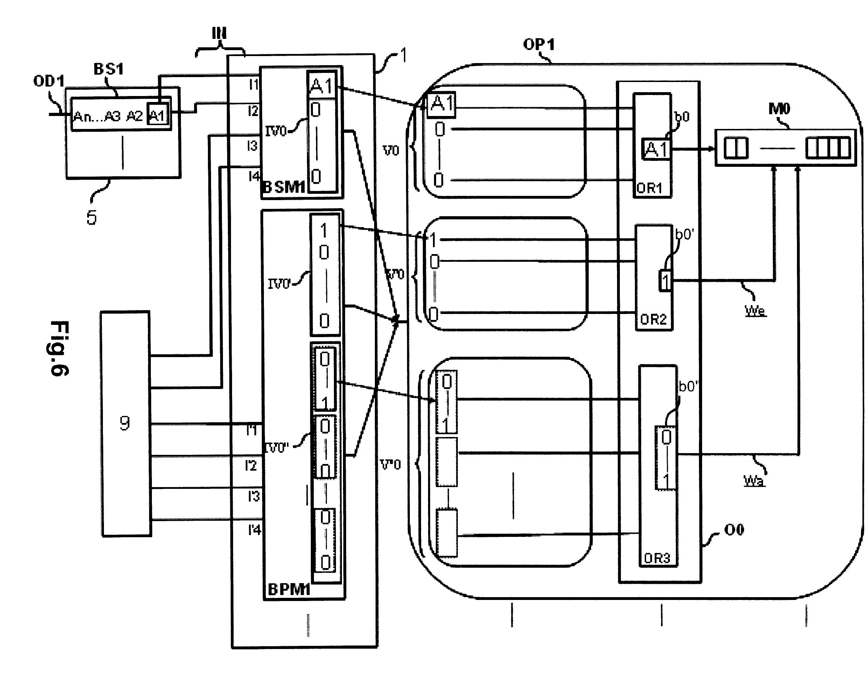

Fig.6 represents the space time switch function of a bit interleaver 7 wherein only one data stream OD1, one bit set BS1 in the FIFO reader 5, one bit shift module BSM1 and one bit position module BPM1 in the space time switch 1 and one output port OP1 are represented for sake of simplicity. It is obvious that a bit interleaver 7 comprises actually a plurality of each of these elements.

The FIFO-reader 5 comprises a bit set BS1 of eight bits noted A1, A2..An corresponding to the first data stream OD 1.

The bit shift module BSM1 and the bit position module BPM1 are dedicated to the first data stream OD 1.

The bit shift module BSM1 comprises four inputs noted I1, I2, I3 and I4, two inputs I3 and I4 linked to the control unit 9 for receiving respectively a rate r associated with the data stream OD1 and an offset o corresponding to the first value position shift of the read bit within an intermediate vector and two inputs, I1 linked to the first input port IP1 for receiving the data bit read from the first bit set BS1 in the FIFO-reader 5 and I2 as index pi representing the position of the bit that has to be be read within the bit set associated with the first data stream OD 1.

The bit shift module BSM1 is configured for providing an intermediate vector IVO comprising N bits (corresponding to the number N of output ports). Among these N bits, only one bit is a data bit corresponding to the read bit and the other N-1 bits are low bits having a zero value. The position p_{f} of the data bit within the output vector is computed according to the index pᵢ, the offset o and the rate r associated with the bit-set and is given by p_{f}=o+(pᵢ*r). The data bit is inserted in a null vector ofN bits and then shifted to the computed position p_{f}. This shifting enables to place correctly the bit

The bit shift module BSM1 also comprises an output for transmitting the bits of the intermediate vector IV0 towards the respective output ports (only one output port OP1 is represented in Fig.6).

The bit position module BPM1 comprises four inputs I'1, I'2, I'3 and I'4 linked to the control unit 9 for receiving respectively an index pᵢ representing the position of the bit that has to be read within the bit set BS1 associated with the first data stream OD1, a rate r associated with the data stream OD1 of the bit that has to be read, an offset o corresponding to the first value position shift of the read bit within an intermediate vector and a position p_{b} representing the absolute position of the bit set within the data stream since the beginning of the global output frame GF.

The bit position module BPM1 is configured for computing a first intermediate vector IV0' which calculus is similar to the intermediate vector IV0 provided by the bit shift module BSM1 and which is destined to provide a write enable instructions to a memory element to enable the writing of the output bit b0 in a memory element M0.

The bit position module BPM1 is also configured for providing a second intermediate vector IV0" comprising N sub-vectors with one sub-vector comprising s bits (with s=abs(log₂(L) with L the number of sub-element in the memory elements M0) for coding the address n of the of the sub-element in which the data bit read by the bit shift module BSM1 has to be written. The address n of the sub-element is given by n=ENT(p_{f}/N) where the ENT function returns the closest smaller integer and N is the number of output ports OP. The bit position module BPM1 is also configured for determining the memory (or the corresponding output port) to which the read bit has to be transmitted. The memory number k is given by k=(MOD(p_{f}; N)) where the MOD function returns the remainder of the ratio p_{f}/N.

The bit position module BPM1 also comprises two outputs, a first output for transmitting the bits of the first intermediate vector IV0' towards the output ports OP1...OPN and a second output for transmitting the sub-vectors of the second intermediate vector IV0" towards the output ports OP1...OPN.

With such configuration, each output port OP comprises three sets of sub-ports.

A first set of N sub-ports for receiving the N bits of the output vector V0 wherein each bit is transmitted by a respective bit shift modules BSM. The sub-ports of this first set are linked respectively to N inputs of a first OR-function element OR1 configured for providing a first output bit b0, corresponding to A1 in the present case, based on the OR function to the associated memory element M0.

A second set of N sub-ports for receiving the N bits of the output vector V0' wherein each bit is transmitted by a first output of a respective bit position module BPM. The sub-ports of this second set are linked respectively to N inputs of a second OR-function element OR2 configured for providing a second output bit b0' based on the OR function to the associated memory element M0. This output bit b0' is used to indicate the writing enable We to the memory element M0.

A third set of N sub-ports, for receiving the N sub-vectors of the output vector V0" wherein each sub-vector is transmitted by a second output of a respective bit position module BPM. The sub-ports of this third set are linked respectively to N inputs of a third OR-function element OR3 configured for providing an output address vector b0" based on the OR function to the associated memory element M0. This output bit b0' is used to indicate the writing address Wa to the memory element M0.

The first OR1, second OR2 and third OR3 OR-function elements are part of the OR-function module O0. The individual OR component can be implemented by programmable components.

As a result, at each clock cycle, the memory element M0 receives one data bit b0 from the first OR-function element, one writing enable bit b0' from the second OR-function element and one address vector b0" from the third OR-function element. The received data bit is then written within the sub-element of the memory having the address corresponding to the received address vector if the writing enable bit is 1.

Thus, the bit shift module BSM1 and the bit position module BPM1 of the space time switch 1 are complementary and comprise inputs configured for receiving a clock signal, for example sent by the control unit 9, enabling the synchronization of the said bit shift module BSM1 and bit position module BPM1. The clock signal is therefore the same for the associated bit shift module and bit position module (BSM1 and BPM1 for example). According to an embodiment of the present invention, a bit shift module BSM and a bit position module BPM may be combined within a single bit processing module which comprises the functions of both modules. A space time switch 1 comprises then a plurality of bit processing modules and each bit processing module is dedicated to a bit of one of the bit sets BS received in the FIFO-reader 5.

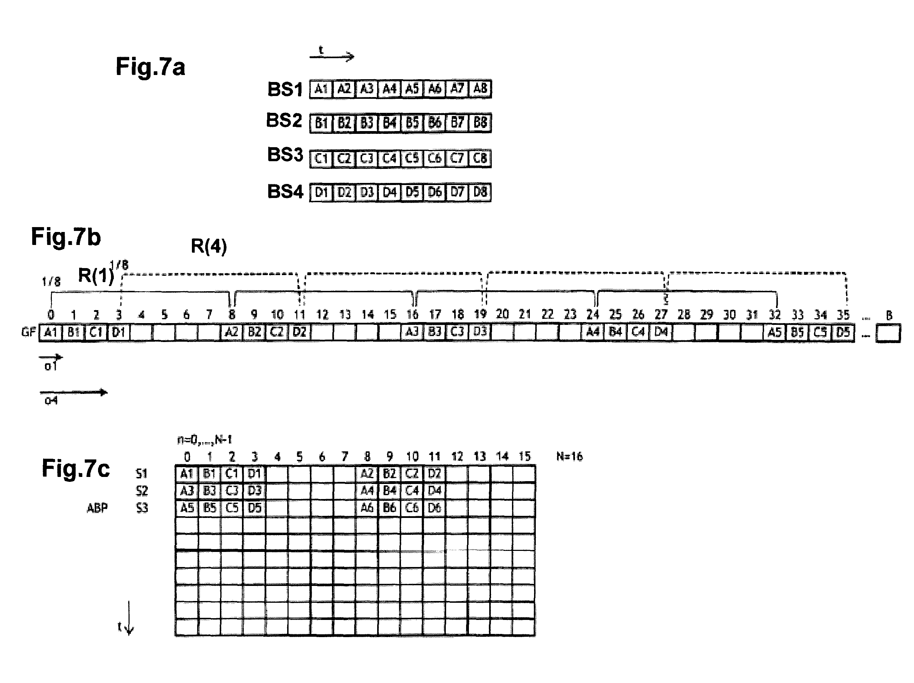

In order to better understand the present invention an example of processing of the bits from their reception by the FIFO reader 5 to their storing within the memory elements MO...M(N-1) will now be described based on Figs 7 to 12.

Figure 7a shows different bit sets BS 1 ...BS4 comprising respectively the bits A1... A8, B1...B8, C1...C8, D1...D8 as sequences over time t. The bit sets BS1...BS4 belongs to the respective data streams OD1...OD4.

Figure 7b shows a bit-interleaving pattern of a global output frame GF, in which the different bits of the bit sets from the Figure 7a are interleaved. Figure 7b shows the interleaving of the different bits of the data streams for the case, that the data rates R(1), R(2), R(3), R(4) are all equal to 1/8 for all the data streams. In other words, all data streams have same rates R(1)...R(4). The maximum number B of bits present within the global output frame GF may be for example 1,228,800 bits. Such a global output frame GF may have a time duration of 122 microseconds.

The first bit of the bit set BS1, which is the bit A1, is placed at the bit position 0 of the global output frame GF. Due to the fact, that the rate R(1) chosen for the data stream OD1 is 1/8, the next bit A2 of the bit set BS1 is placed 8 further bits apart from the first bit A1, such that the bit A2 is placed in the bit position 8. Further bits A3, A4, A5 of the bit set BS1 follow at next bit positions 16, 24, 32 within the global output frame GF.

For the shown bit-interleaving scheme placing bits within a global output frame GF, the bit position bp(x(i),i) of the x-th bit of the data stream with index i can be in general determined, by using the reciprocal value r(i)=1/R(i) of the rate R(i), an offset value o(i) and an integer value x(i). The integer value x(i) corresponds to the index number of the x-th bit and is thus an integer number ranging from x(i)=0 up to the integer value x(i)=int(B/r(i)). Thus, the bit position bp(x(i),i) of the x-th bit of the bit set with index i can be determined for decimal numbers as bp(x(i),i)=o(i)+r(i)*x(i).

Thus, the control unit 9 determines for the x-th bit of the i-th bit set a corresponding bit-position within the global output frame GF.

In this example, the offset value o(1) is chosen to o(1)=0 for the bit set BS1. In Figure 7b, it is also shown the relationship of the bits D1, D2, ... of the bit set BS4 within the global output frame GF. Due to the fact, that the rate R(4) is also chosen as R(4)=1/8 for this bit-interleaving scheme, also the bits D1, D2, ... of the data stream OD4 are each spaced 8 bit positions apart within the global frame GF. The offset value o(4) is chosen as the value o(4)=3 in this example. The offset values for the bits of the data streams OD2, OD3 are not explicitly shown in the Figure 7b, but it can be said, that the offset value o(2) is chosen to the value o(2)=1, while the offset value o(3) is chosen to the value o(3)=2.

Looking at Figure 7b, it becomes clear, that if the bit interleaver 7 is implemented within an optical line terminal (OLT) of a bit interleaving passive optical network (BiPON), the optical network units (ONUs) receiving this global output frame GF may perform reception of bits of one of the data streams at a data rate, which is equal to data rate of the global output frame GF divided by 8.

Figure 7c shows an alternative bit pattern ABP, in which the different bits of the global output frame GF shown in Figure 7b are split into sets of N bits, with N=16 in the present case. Over time, different sets ofN bits may be read out from N memory elements M0, ..., M(N-1) as shown in Figure 5, and later on be successfully transmitted for realizing a transmission of a bit sequence corresponding to the global output frame GF shown in Figure 7b.

The first set, which has to be read in a first reading cycle from the memories M0, ..., M(N-1) shown in Figure 5, is the set S1. The bits of this set S1 correspond to those bits, which are stored within the bit positions 0 to 15 of the global output frame GF of Figure 7b.

Within a next reading cycle, the next set of bits S2, shown in the Figure 7c, shall be read out from the memory elements M0, ..., M(N-1) shown in Figure 5. These are the bits allocated to the bit positions 16 to 31 of the global output frame GF shown in Figure 7b.

Within a third reading cycle, the set of bits S3, shown in Figure 7c, shall be read out from the memory elements M0, ..., M(N-1) shown in Figure 5. These are the further bits starting at the bit positions 32 of the global output frame GF shown in Figure 7b.

It will be now explained in detail, in which way different bits of different data streams are to be switched by the space time switch 1 and written to the memories M0, ..., M(N-1), shown in Figure 5 and furthermore also read from these memories.

The number of the output ports and thus also the number of the corresponding output vectors, to which the space time switch 1 switches a specific bit, is controlled by the control unit 9. The control unit 9 determines the number of the output ports, and thus the number of the output vectors and also the resulting number of the memory M0, ..., M(N-1), to which a bit is switched.

For each bit, the bit position bp is determined by the control unit 9 as previously described above.

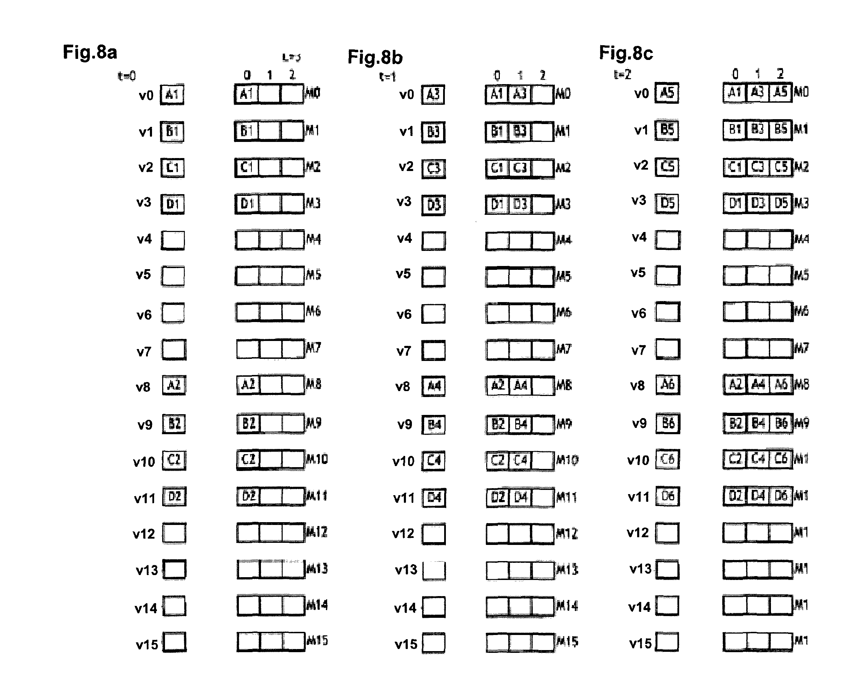

Figure 8a shows furthermore the different states of the different memory elements M0, ...,M15 at a time instance t=0. The different OR-function elements reduce the different output vectors v0, ..., v15 to single output bits b0, ..., b(N-1), which are then written into respective sub-elements or bit-sub-elements of respective memories M0, ..., M(N-1), wherein these bit sub-elements are of a same writing address. In this example, the writing address is equal to 0. The control unit 9 determines within one writing cycle for the x-th bit of the i-th data stream the writing address wa in dependence on the bit position of the x-th bit of the i-th data stream and the number L of sub-elements in the memory elements M0,...,M(N-1).

Looking at the memory elements M0, ..., M15 at the time instance t=0, an appropriate set of N bits, shown as the bit set S1 in Figure 7c, can be read from the memories, by reading out all the memories M0, ..., M15 at one time instance with a same reading address. In this example, the reading address is equal to the value 0.

This reading has not to be performed exactly at a time instance at which the bits have finally been written into the memory elements M0, ..., M15, but may be performed at a later point in time. The reading of the bits from the memory elements M0, ..., M15 with the appropriate reading address is controlled and determined by the control unit 9 shown in Figure 5.

Within a next writing cycle, the space time switch 1 switches bits of the different bit sets onto output ports and into corresponding output vectors v0, ..., v15 to produce single bits b0...b15 at the time instance t=1, as shown in Figure 8b which are then written at this time instance t=1 into respective bit sub-elements of the memory elements M0, ..., M15, as shown in Figure 8b.

Within this next writing cycle, the control unit 9 determines for the x-th bit of the i-th data stream the number of the output port and thus the number of the memory element, to which the resulting output bit is written.

By looking at Figure 8b, it becomes evident, that a next set of N=16 bits can be read out from the memory elements M0, ..., M15, by reading out the 16 bits present within these memory elements at same reading addresses, which, in this example, are the reading address of the value 1.

Thus, when having to read successive sets of N bits from the different memory elements, for forming a bit sequence corresponding to a global output frame GF of a BIPON scheme, one may simply read out such N bits from the N memory elements, using a same reading address for all of these N memory elements within a same reading cycle and then simply increasing the reading address for the next reading cycle.

For the further bits A5, ..., D6, the Figure 8c shows for a next time instance t=2, in which way the proposed choice for switching these bits and writing these bits into the memories M0, ...,M15 leads to a placement of the bits within the memory elements at specific bit sub-elements.

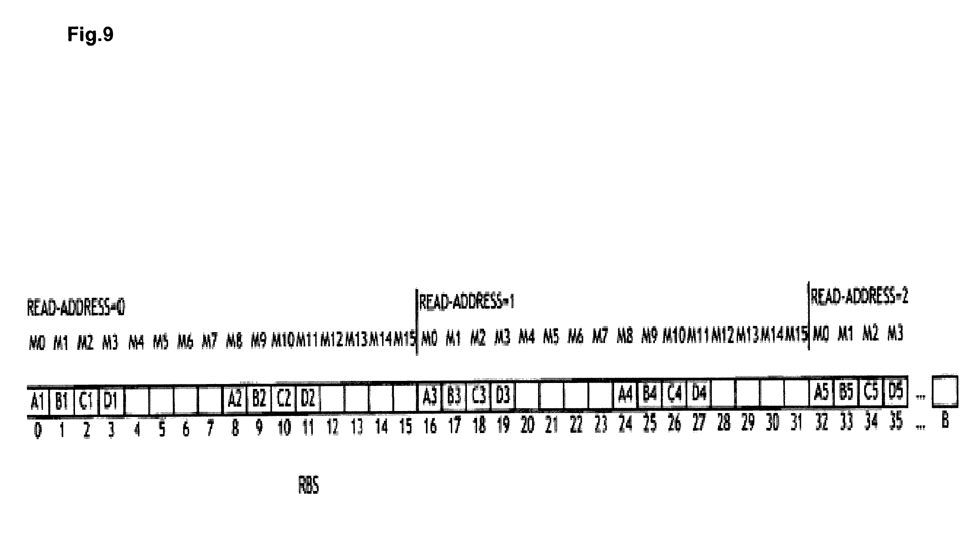

A resulting bit sequence RBS, shown in Figure 8, results from reading sets of N bits from the N memory elements with a same reading address within each respective reading cycle. By comparing the resulting bit sequence RBS of Figure 9 with the initially desired bit sequence of the global output frame GF in Figure 7b, it become clear, that the proposed bit-interleaver BI in Figure 5 is able to perform the desired bit-interleaving of a global output frame GF shown in Figure 7b.

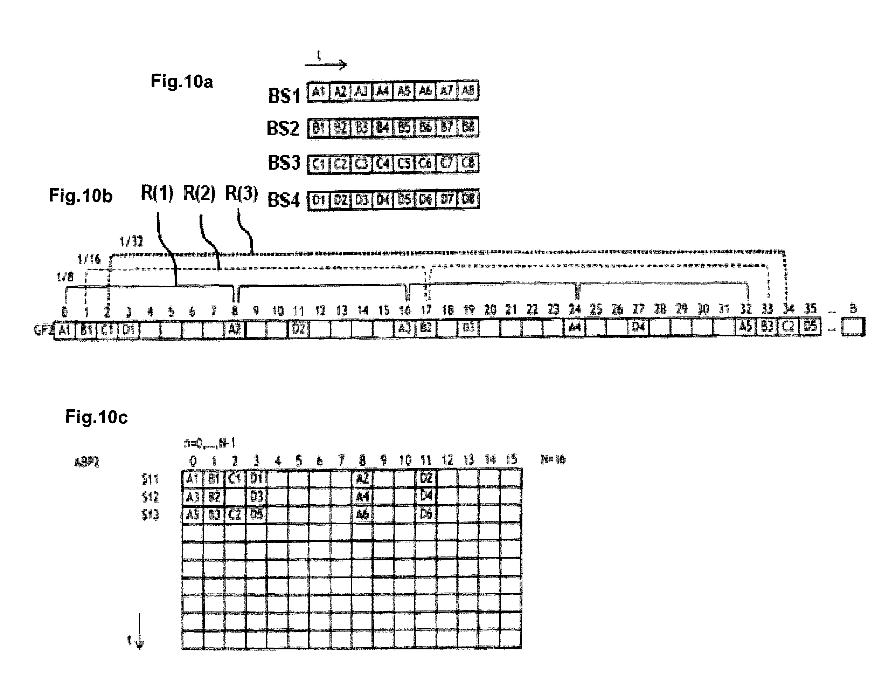

Figure 10a shows once again the different bit sets BS1...BS4.

Figure 10b shows a desired bit sequence of a global output frame GF2 in the case, that the data stream OD1 shall be interleaved at a rate R(1)=1/8 and also the data stream OD4 shall be interleaved at a rate 1/8, while the data stream OD2 shall be interleaved at a rate R(2)= 1/16 and the data stream OD3 shall be interleaved at rate R(3)= 1/32.

The offset values of the different data streams are chosen as previously described with regard to Figure 7b.

Figure 10c shows the corresponding alternative bit pattern ABP2 with sets of N=16 bits over time t. The resulting sets of bits S11, S12, S 13 are such, which shall be present within the memory elements M0, ..., M(N-1) at bit sub-elements of same addresses, as shown in Figure 5.

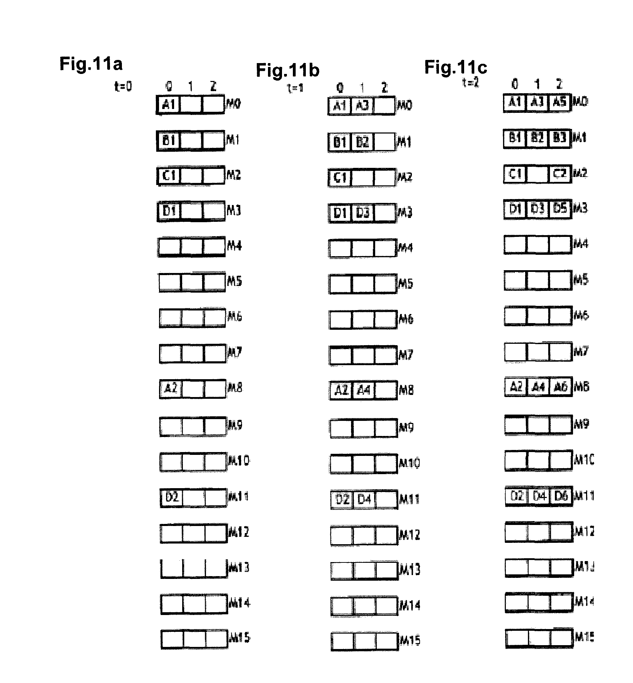

Figure 11a shows the resulting placement of the different bits A1, ..., D2 within the memory element M0, ..., M15 at time t=0.

At the next time instance t=1, the bits of the set S12 shown in Figure 11b are placed within the output vectors v0, ..., v15 and then in the single bits b0...b15.

The resulting single output bits are then written within one writing cycle corresponding to the time instance t=1 into the bit sub-elements.

For the next further time instance t=2, Figure 11c shows the placement of the different bits within the bit-sub-elements of a same writing address, equal to the value 2, of the memory elements M0, ..., M15.

By looking at Figure 11c, it becomes evident, that it is now possible to read out at successive reading cycles respective sets of N bits from the different memory elements M0, ..., M15, wherein within one reading cycle a same reading address is used for choosing the bit sub-element of each memory element M0, ..., M15.

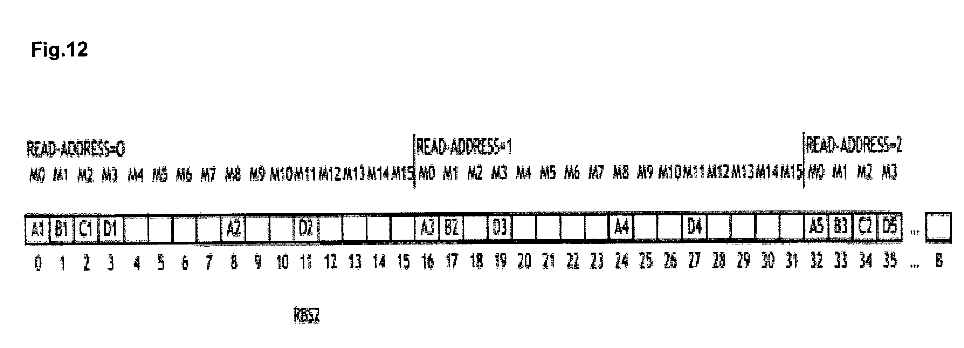

By reading out sets of N bits from the memory elements as previously described above within successive reading cycles, a resulting bit pattern RBS2 can be achieved, as shown in Figure 12.

By comparing the bit sequence RBS2 of Figure 12 with the desired bit sequence of bits of the global frame GF2 of Figure 10b, it becomes evident, that the proposed bit-interleaver BI shown in Figure 5 achieves the desired method of bit-interleaving needed for a BIPON transmission.

The choice of the number of bit sub-elements to L=3 is only a simple exemplary choice. In practice, the number of bit-sub-elements present within a memory element is for example chosen to be L=1024.

For achieving an overall data rate of 10 gigabit per second, one may choose the number N equal to 64, while reading out such sets ofN bits at a rate or frequency of f=156,25 MHz. As an alternative example, sets of N=32 bits may be written and read at a frequency of f=312,5 MHz for achieving the same bit rate of 10 gigabit per second. Even alternatively, one may choose the number of N to N=128 with a reading frequency of f=78,125 MHz.

It is an evident advantage of the bit-interleaver BI shown in Figure 5, that the global latency of the system is low, since the reading process of interleaved bits from the memory elements M0, ..., M(N-1) can be started, before all the interleaving processes of all bits forming a global frame is finished.

Preferably, the different sub-devices of the bit interleaver 7 shown in Figure 5 are implemented within a single field programmable gate array (FPGA) and the memory reader is a FIFO-reader.

### 3) Space time switch as a frequency switching module

Based on the architecture of the switch space time 1 presented previously, additional functions may be achieved such as a frequency switching of the data streams received in the FIFO reader 5. Indeed, instead of providing the bit position modules BPM dedicated to a data stream with a rate r corresponding to the rate of the data stream, the control unit 9 may provide a higher rate to these bit position modules which will provide a shifting of the data stream frequency within the global output frame GF. For example, a data stream received with a rate r=8 may be switched to a rate of 16, 32 or 64 within the global output frame GF by providing the bit position module with a data rate of 16, 32 or 64. As a consequence, the bits read from the data stream having a rate r=8 will be switched in the sub-elements of the memory elements M0...M(N-1) in order to be placed 16, 32 or 64 further bits apart from each other.

The functions of the various elements shown in the Figures 1, 2, 3 or 4, including any functional blocks may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'control unit' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

Thus, the different embodiments of the present invention refer to a space time switch comprising processing means including a plurality of processing modules which are implemented by programmable components such as Field Programmable Gate Array "FPGA" or Application Specific Integrated Circuit "ASIC" components or a combination of Field Programmable Gate Array "FPGA" components with a system on chip "SoC". Such components enable processing up to N bits in parallel simultaneously. As consequence with the architectures described previously, N data bits are switched toward a computed output port at each clock cycle. Thus, according to the first embodiment, the bit shift module may lead to an N(k bits)*N(k bits) switch with a granularity of k bits and wherein the N bits are switched simultaneously toward a predefined output port. According to the second embodiment, the space time switch may be use in a bit interleaver allowing low latency and capable of processing data streams having different bit rates. Furthermore, the use of a plurality of memory elements allows reading simultaneously a plurality of bits from the said memory elements to produce a global output frame ready to be transmitted toward the optical line terminals (OLTs) without latencies. According to the third embodiment, the bit interleaver enables to switch the frequency or rate of a data stream, for example to adapt the said data stream to an OLT having a low capacity memory.

## Claims

1. Space time switch (1) comprising up to M input ports (IP) and up to N output ports (OP), the said space time switch (1) also comprises processing means (3) configured for:
- reading within one clock cycle up to N bits on its input ports (IP), the said N bits being read from F bit-sets (BS) of respective F data streams (OD),
- switching within one clock cycle up to N read bits onto the N respective output ports (OP),
wherein the processing means (3) are implemented by programmable components configured for processing up to N bits in parallel simultaneously.

2. Space time switch (1) in accordance with claim 1 wherein the programmable components are Field Programmable Gate Array "FPGA" or Application Specific Integrated Circuit "ASIC" components or a combination of Field Programmable Gate Array "FPGA" components with a system on chip "SoC".

3. Space time switch (1) in accordance with claim 1 or 2 wherein the output ports (OP) comprise k sub-ports, the processing means (3) comprise at least N*k bit shift modules (BSM) wherein a bit shift module (BSM) is configured for:
- reading a data bit from one of the F bit-sets (BS),
- receiving an index of an output port (OP) associated to the read bit and,
- providing, within one clock cycle, an intermediate vector (IV) comprising N*k bits with one data bit corresponding to the read bit, the position of the data bit in the intermediate vector being computed according to the index of the associated output port (OP), the other bits of the intermediate vector (IV) being null values and the respective N*k bits of the intermediate vector (IV) being sent to one of the k sub-ports of the respective N output ports (OP).

4. Space time switch (1) in accordance with claim 1 or 2 wherein it comprises inputs (IN) for receiving a rate and an offset associated with the F respective bit-sets (BS) and wherein the processing means (3) comprise:
- at least N bit shift modules(BSM) wherein a bit shift module (BSM) comprises
- an input (I1) for receiving a bit read from one of the F bit-sets (BS),
- an input (I2) for receiving an index of the read bit within the bit-set (BS),
- an input (I3) for receiving an offset associated to the bit-set (BS),
- an input (I4) for receiving a rate associated to the bit-set (BS),
and is configured for providing, within one clock cycle, an intermediate vector (IV) comprising N bits with one data bit corresponding to the read bit, the position of the data bit in the intermediate vector (IV) being computed according to:
- the index of the received bit within the bit set (BS),
- the offset associated with the bit-set (BS),
- the rate associated with the bit-set (BS),
the N respective bits of the intermediate vector (IV) being sent to the respective N output ports (OP) to form an output vector (V),
- at least N bit position modules (BPM) wherein a bit position module (BPM) comprises
- an input (I'1) for receiving an index of the bit within the bit-set,
- an input (I'2) for receiving an offset associated to the bit-set,
- an input (I'3) for receiving a rate associated to the bit-set,
- an input (I'4) for receiving the position of the bit-set within the data stream and is configured for providing
- a first intermediate vector (IV') comprising N bits with one enabling bit, the position of the enabling bit being computed according to the index of the received bit within the bit set (BS), the offset and rate associated with the bit-set (BS), the respective bits of the first intermediate vector (IV') being sent to the respective N output ports (OP) to form an output vector (V'),
- a second intermediate vector (IV") comprising N sub-vectors of abs(log₂(L)) bits with one address sub-vector, the position of the address sub-vector being computed according to the index of the received bit within the bit set (BS), the offset and rate associated with the bit-set (BS), the position of the bit-set (BS) within a global output frame (GF), the respective sub-vectors of the second intermediate vector (IV") being sent to the respective N output ports (OP) to form an output vector (V").

5. Space time switch (1) in accordance with claim 4 wherein the bit shift modules (BSM) and bit position modules (BPM) comprise inputs configured for receiving a clock signal enabling the synchronization of the said bit shift (BSM) and bit position (BPM) modules.

6. Bit interleaver (7) comprising:
- a space time switch (1) in accordance with claim 4 or 5,
- a memory reader (5) operable to receive up to M data streams (OD) having respective bit-rates and to provide up to M bit-sets (BS) to the input ports (IP) of the space time switch (1),
- N OR-function modules (O) linked respectively to the N output ports (OP) and operable to determine within one clock cycle a single output bit (b) based on one of said respective output vectors (V),
- N memory elements (M) linked respectively to the N OR-function modules (O) and comprising respectively at least L sub-elements having respective sub-addresses, the said memory elements (M) being operable to write within one clock cycle one single output bit (b) into one of its bit sub-elements.

7. Bit interleaver (7) in accordance with claim 6 wherein the OR-function modules comprise:
- a first OR-function element (OR1) comprising N inputs for receiving an output vector (V) comprising N bits received from N bit shift modules (BSM) and configured for providing one output bit (b) based on the OR function to the associated memory element (M),
- a second OR-function element (OR2) comprising N inputs for receiving an output vector (V') comprising N bits received from N bit position modules (BPM) and configured for providing one output bit (b) based on the OR function to the associated memory element (M),
- a third OR-function element (OR3) comprising N inputs for receiving N output vectors (V") comprising abs(log₂(L)) bits from N bit position modules (BPM) and configured for providing a vector of abs(log₂(L)) bits based on the OR-function to the associated memory element (M).

8. Bit interleaver (7) in accordance with one of the claims from 6 to 7 wherein it comprises a control unit (9) configured for providing, to the bit shift modules (BSM) and to the bit position modules (BPM), the rate and the offset associated with the bit-sets (BS) that the bit shift modules (BSM) and the bit position modules (BPM) have to process.

9. Bit interleaver (7) in accordance with one of the claims from 6 to 7 in combination with claim 8 wherein the control unit (9) is configured for providing a clock signal to the bit shift modules (BSM) and to the bit position modules (BPM) and wherein a bit shift module (BSM) and an associated bit position module (BPM) are configured to be clocked based on the same clock signal.

10. Bit interleaver (7) in accordance with claim 9 wherein bit shift modules (BSM) and associated bit position modules (BPM) are combined respectively to form N processing modules.

11. Bit interleaver (7) in accordance with one of the claims from 6 to 10 wherein it comprises a memory reader (5) operable to receive and provide a number of F data streams (OD) with respective rates.

12. Bit interleaver (7) in accordance with one of the claims from 6 to 11 in combination with claim 8 wherein the rate associated to a bit-set (BS) provided by the control unit (9) is selected to be lower than the rate of the received data stream (OD) comprising the said bit-set (BS) leading to a modification of the rate of the data stream (OD) within the output global frame (GF).

13. Bit interleaver in accordance with claims 6 to 8 wherein the bit interleaver is located in an optical line terminal of an optical access network wherein:
- the memory reader (5) is operable to receive and provide a number of F data streams (OD) assigned to respective optical network units,
- the control unit (9) is operable to control:
- the reading of said M data streams (OD) by the space time switch (1),
- the switching of the said space time switch (1) onto said output ports (OP) and
- the writing of the single output bits (b) within the memory elements (M) according to a calculated pattern.

14. Optical line terminal for an optical access network comprising a bit interleaver in accordance with claim 13.

## Amended claims

### Amended claims in accordance with Rule 137(2) EPC.

1. Space time switch (1) comprising up to M input ports (IP) and up to N output ports (OP), the said space time switch (1) also comprises processing means (3) configured for:
- reading within one clock cycle up to N bits on its input ports (IP), the said N bits being read from F bit-sets (BS) of respective F data streams (OD),
- switching within one clock cycle up to N read bits onto the N respective output ports (OP) by providing intermediate vectors of N bits, the respective N bits of the intermediate vectors being sent to the respective N output ports,
wherein the processing means (3) are implemented by programmable components configured for processing up to N bits in parallel simultaneously.

2. Space time switch (1) in accordance with claim 1 wherein the programmable components are Field Programmable Gate Array "FPGA" or Application Specific Integrated Circuit "ASIC" components or a combination of Field Programmable Gate Array "FPGA" components with a system on chip "SoC".

3. Space time switch (1) in accordance with claim 1 or 2 wherein the output ports (OP) comprise k sub-ports, the processing means (3) comprise at least N*k bit shift modules (BSM) wherein a bit shift module (BSM) is configured for:
- reading a data bit from one of the F bit-sets (BS),
- receiving an index of an output port (OP) associated to the read bit and,
- providing, within one clock cycle, an intermediate vector (IV) comprising N*k bits with one data bit corresponding to the read bit, the position of the data bit in the intermediate vector being computed according to the index of the associated output port (OP), the other bits of the intermediate vector (IV) being null values and the respective N*k bits of the intermediate vector (IV) being sent to one of the k sub-ports of the respective N output ports (OP).

4. Space time switch (1) in accordance with claim 1 or 2 wherein it comprises inputs (IN) for receiving a rate and an offset associated with the F respective bit-sets (BS) and wherein the processing means (3) comprise:
- at least N bit shift modules(BSM) wherein a bit shift module (BSM) comprises
- an input (I1) for receiving a bit read from one of the F bit-sets (BS),
- an input (I2) for receiving an index of the read bit within the bit-set (BS),
- an input (I3) for receiving an offset associated to the bit-set (BS),
- an input (I4) for receiving a rate associated to the bit-set (BS),
and is configured for providing, within one clock cycle, an intermediate vector (IV) comprising N bits with one data bit corresponding to the read bit, the position of the data bit in the intermediate vector (IV) being computed according to:
- the index of the received bit within the bit set (BS),
- the offset associated with the bit-set (BS),
- the rate associated with the bit-set (BS),
the N respective bits of the intermediate vector (IV) being sent to the respective N output ports (OP) to form an output vector (V),
- at least N bit position modules (BPM) wherein a bit position module (BPM) comprises
- an input (I'1) for receiving an index of the bit within the bit-set,
- an input (I'2) for receiving an offset associated to the bit-set,
- an input (I'3) for receiving a rate associated to the bit-set,
- an input (I'4) for receiving the position of the bit-set within the data stream and is configured for providing
- a first intermediate vector (IV') comprising N bits with one enabling bit, the position of the enabling bit being computed according to the index of the received bit within the bit set (BS), the offset and rate associated with the bit-set (BS), the respective bits of the first intermediate vector (IV') being sent to the respective N output ports (OP) to form an output vector (V'),
- a second intermediate vector (IV") comprising N sub-vectors of abs(log₂(L)) bits with one address sub-vector, the position of the address sub-vector being computed according to the index of the received bit within the bit set (BS), the offset and rate associated with the bit-set (BS), the position of the bit-set (BS) within a global output frame (GF), the respective sub-vectors of the second intermediate vector (IV") being sent to the respective N output ports (OP) to form an output vector (V").

5. Space time switch (1) in accordance with claim 4 wherein the bit shift modules (BSM) and bit position modules (BPM) comprise inputs configured for receiving a clock signal enabling the synchronization of the said bit shift (BSM) and bit position (BPM) modules.

6. Bit interleaver (7) comprising:
- a space time switch (1) in accordance with claim 4 or 5,
- a memory reader (5) operable to receive up to M data streams (OD) having respective bit-rates and to provide up to M bit-sets (BS) to the input ports (IP) of the space time switch (1),
- N OR-function modules (O) linked respectively to the N output ports (OP) and operable to determine within one clock cycle a single output bit (b) based on one of said respective output vectors (V),
- N memory elements (M) linked respectively to the N OR-function modules (O) and comprising respectively at least L sub-elements having respective sub-addresses, the said memory elements (M) being operable to write within one clock cycle one single output bit (b) into one of its bit sub-elements.

7. Bit interleaver (7) in accordance with claim 6 wherein the OR-function modules comprise:
- a first OR-function element (OR1) comprising N inputs for receiving an output vector (V) comprising N bits received from N bit shift modules (BSM) and configured for providing one output bit (b) based on the OR function to the associated memory element (M),
- a second OR-function element (OR2) comprising N inputs for receiving an output vector (V') comprising N bits received from N bit position modules (BPM) and configured for providing one output bit (b) based on the OR function to the associated memory element (M),
- a third OR-function element (OR3) comprising N inputs for receiving N output vectors (V") comprising abs(log₂(L)) bits from N bit position modules (BPM) and configured for providing a vector of abs(log₂(L)) bits based on the OR-function to the associated memory element (M).

8. Bit interleaver (7) in accordance with one of the claims from 6 to 7 wherein it comprises a control unit (9) configured for providing, to the bit shift modules (BSM) and to the bit position modules (BPM), the rate and the offset associated with the bit-sets (BS) that the bit shift modules (BSM) and the bit position modules (BPM) have to process.

9. Bit interleaver (7) in accordance with one of the claims from 6 to 7 in combination with claim 8 wherein the control unit (9) is configured for providing a clock signal to the bit shift modules (BSM) and to the bit position modules (BPM) and wherein a bit shift module (BSM) and an associated bit position module (BPM) are configured to be clocked based on the same clock signal.

10. Bit interleaver (7) in accordance with claim 9 wherein bit shift modules (BSM) and associated bit position modules (BPM) are combined respectively to form N processing modules.

11. Bit interleaver (7) in accordance with one of the claims from 6 to 10 wherein it comprises a memory reader (5) operable to receive and provide a number of F data streams (OD) with respective rates.

12. Bit interleaver (7) in accordance with one of the claims from 6 to 11 in combination with claim 8 wherein the rate associated to a bit-set (BS) provided by the control unit (9) is selected to be lower than the rate of the received data stream (OD) comprising the said bit-set (BS) leading to a modification of the rate of the data stream (OD) within the output global frame (GF).

13. Bit interleaver in accordance with claims 6 to 8 wherein the bit interleaver is located in an optical line terminal of an optical access networkwherein:
- the memory reader (5) is operable to receive and provide a number of F data streams (OD) assigned to respective optical network units,
- the control unit (9) is operable to control:
- the reading of said M data streams (OD) by the space time switch (1),
- the switching of the said space time switch (1) onto said output ports (OP) and
- the writing of the single output bits (b) within the memory elements (M) according to a calculated pattern.

14. Optical line terminal for an optical access network comprising a bit interleaver in accordance with claim 13.
